# EUROPÄISCHE PATENTSCHRIFT

(11) **EP 3 937 599 B1**
(45) Veröffentlichungstag und Bekanntmachung des Hinweises auf die Patenterteilung: **07.05.2025**
(21) Anmeldenummer: 21176378.4
(22) Anmeldetag: 27.05.2021
(51) Int. Cl.: H05K 5/00, H05K 5/04, H05K 5/06

(54) **GEHÄUSE UND VERFAHREN ZUR MONTAGE EINES GEHÄUSES**
HOUSING AND METHOD FOR MOUNTING A HOUSING
LOGEMENT ET PROCÉDÉ DE MONTAGE D'UN LOGEMENT

(30) Priorität: 06.07.2020 DE 102020117782
(43) Veröffentlichungstag der Anmeldung: 12.01.2022
(73) Patentinhaber: Aptiv Technologies AG, 8200 Schaffhausen (CH)
(72) Erfinder: Slawik, Ralf, 91126 Schwabach (DE); Sheikha, Majed, 55545 Bad Kreuznach (DE); Ambach, Bernd, 91126 Rednitzhembach (DE)
(74) Vertreter: Manitz Finsterwald Patent- und Rechtsanwaltspartnerschaft mbB

(56) Entgegenhaltungen:
- DE-B3- 102015 217 572
- US-A1- 2019 069 426

## Beschreibung

Die vorliegende Offenbarung betrifft ein Gehäuse, insbesondere für ein Steuergerät, und ein Verfahren zur Montage eines Gehäuses.

Steuergeräte weisen zum Schutz von Platinen (auch Leiterplatten genannt) häufig Abdeckungen, die direkt auf der Platine befestigt werden können, oder Gehäuse auf, die aus zwei miteinander verschraubten Gehäuseteilen bestehen und in denen die Platine aufgenommen ist. Das Verschrauben der Gehäuseteile ist jedoch arbeitsaufwändig und dichtet die Verbindungsstelle der beiden Gehäuseteile nicht zuverlässig ab.

Die Druckschrift DE 10 2015 217 572 B3 offenbart ein Steuergerät mit einer Leiterplatte und einem Gehäusedeckel, deren umlaufende Randbereiche mit einem Polymer umspritzt sind. Eine Kommunikationseinheit mit einem Gehäuse ist aus der Druckschrift US 2019/0069426 A1 bekannt.

Es ist die Aufgabe der Erfindung, ein Gehäuse zu schaffen, das gegenüber dem Stand der Technik nach außen gut abgedichtet ist und dessen Montage gleichzeitig vereinfacht ist.

Die Lösung dieser Aufgabe erfolgt durch die Merkmale von Anspruch 1.

Gemäß einem Aspekt betrifft die vorliegende Offenbarung ein Gehäuse, insbesondere für ein Steuergerät, umfassend ein erstes Gehäuseteil aus Metall, welches einen umlaufend abragenden ersten Flansch aufweist, und ein zweites Gehäuseteil aus Metall, welches einen umlaufenden zweiten Flansch aufweist, wobei der erste Flansch und der zweite Flansch in einem Kontaktbereich aufeinander liegen, sodass das erste Gehäuseteil und das zweite Gehäuseteil gemeinsam einen abgeschlossenen Hohlraum begrenzen, und wobei an den Kontaktbereich ein Rahmen aus Kunststoff selbst außen um den Rand umlaufend derart angeformt ist, dass er die Flansche mit dem Kontaktbereich vollständig umschließt, um die Gehäuseteile miteinander zu verbinden und den Hohlraum nach außen abzudichten.

Durch den Rahmen können die Gehäuseteile insbesondere nicht lösbar miteinander verbunden werden, das heißt zum Öffnen ist es erforderlich, den Rahmen zu zerstören. Das Gehäuse und eine darin aufgenommene Platine werden dabei jedoch nicht beeinträchtigt, sodass Reparaturen möglich sind und das Gehäuse anschließend erneut verschlossen werden kann.

Die Gehäuseteile, die insbesondere aus Aluminium oder Stahl hergestellt sein können, liegen mit den beiden Flanschen in dem Kontaktbereich aufeinander, sodass der Hohlraum vollständig und umlaufend abgeschlossen und durch den Rahmen aus Kunststoff auch abgedichtet ist. Der Rahmen wird angeformt, insbesondere angespritzt. Dies ermöglicht ein schnelles und spanloses Verbinden der Gehäuseteile in weniger als einer halben Minute, wobei auf Schrauben verzichtet werden kann. Zudem kann auf Standardgehäuseteile zurückgegriffen werden.

Gemäß einer Ausführungsform weist das Gehäuse ein Befestigungselement zum Befestigen des Gehäuses an einer Umgebungsstruktur auf. Dies kann insbesondere in bewegten Umgebungsstrukturen wie in Kraftfahrzeugen nützlich sein.

Das Befestigungselement kann dazu wenigstens eine von dem Gehäuse und/oder dem Rahmen abragende Befestigungsplatte aufweisen. Die Befestigungsplatte kann beispielsweise ein Beschlag sein und eine Öffnung aufweisen, um das Gehäuse mittels Verbindungselementen, insbesondere Schrauben, an der Umgebungsstruktur zu befestigen.

Gemäß einer Ausführungsform ist die Befestigungsplatte durch den Rahmen an dem Gehäuse befestigt, insbesondere indem der Rahmen im Bereich der Befestigungsplatte derart angeformt wird, dass ein Teil der Befestigungsplatte durch das Gehäuse und den Rahmen umgeben ist und die Befestigungsplatte dadurch festgelegt ist.

Das Befestigungselement kann bei einer Ausführungsform zwei von dem Gehäuse und/oder dem Rahmen abragende Befestigungsplatten an gegenüberliegenden Seiten des Gehäuses aufweisen. Dadurch ist eine sichere Befestigung des Gehäuses an der Umgebungsstruktur möglich.

In dem Hohlraum kann gemäß einer Ausführungsform eine Platine angeordnet sein. Die Platine kann insbesondere stoffschlüssig, beispielsweise geklebt, und/oder formschlüssig in dem Hohlraum festgelegt sein.

Der Rahmen kann im Querschnitt U-förmig ausgebildet sein, um präzise an den Flanschen anzuliegen und die Flansche zu umschließen.

Gemäß einer Ausführungsform kann das zweite Gehäuseteil eine umlaufende Stufe aufweisen, an der das erste Gehäuseteil, insbesondere mit einem Übergangsbereich zwischen einer Seitenwand des ersten Gehäuseteils und dem ersten Flansch, anliegt. Die umlaufende Stufe kann beispielsweise in einem Übergangsbereich zwischen dem zweiten Flansch und einer Hauptfläche des zweiten Gehäuseteils oder an einem freien Ende des zweiten Flansches ausgebildet sein.

An der Stufe ergibt sich ein umlaufender Kontakt der Gehäuseteile zueinander, wodurch diese zueinander gegen Verrutschen gesichert sind.

Gemäß einem weiteren Aspekt betrifft die vorliegende Offenbarung ein Verfahren zur Montage eines Gehäuses, umfassend ein erstes Gehäuseteil aus Metall, welches einen umlaufend abragenden ersten Flansch aufweist, und ein zweites Gehäuseteil aus Metall, welches einen umlaufenden zweiten Flansch aufweist, wobei das Verfahren die folgenden Schritte umfasst:
Anordnen des ersten Gehäuseteils und des zweiten Gehäuseteils in einem Formwerkzeug, insbesondere einem Spritzgusswerkzeug, sodass der erste Flansch und der zweite Flansch in einem Kontaktbereich aufeinander liegen und das erste Gehäuseteil und das zweite Gehäuseteil gemeinsam einen abgeschlossenen Hohlraum begrenzen, und
Anformen, insbesondere Anspritzen, eines Rahmens aus Kunststoff derart, dass dieser selbst außen um den Rand umlaufend derart an dem Kontaktbereich angebracht ist, dass er die Flansche mit dem Kontaktbereich vollständig umschließt.

Durch dieses Verfahren können die Gehäuseteile schnell und sicher zu einem Gehäuse verbunden werden. Das Bohren und Schneiden von Gewinden, um die Gehäuseteile miteinander verschrauben zu können, entfällt.

Bei einer Ausführungsform wird vor dem Anformen des Rahmens wenigstens eine von dem Gehäuse und/oder dem Rahmen abragende Befestigungsplatte an wenigstens einem der Flansche angebracht und ein Teil der Befestigungsplatte beim Anformen des Rahmens zwischen dem Rahmen und dem wenigstens einen Flansch eingeschlossen, um die Befestigungsplatte an dem Gehäuse zu befestigen.

Gemäß einer Ausführungsform kann bei dem Verfahren vor dem Anformen des Rahmens eine Platine in dem Hohlraum angeordnet werden. Insbesondere kann die Platine stoffschlüssig, beispielsweise geklebt, und/oder formschlüssig in dem Hohlraum festgelegt werden.

Die vorliegende Offenbarung wird nachfolgend anhand von einem Ausführungsbeispiel mit Bezug auf die Zeichnungen beschrieben, bei denen
- Fig. 1: ein Ausführungsbeispiel eines Gehäuses mit einem Befestigungselement und
- Fig. 2: einen Querschnitt durch das Gehäuse aus Fig. 1 zeigt.

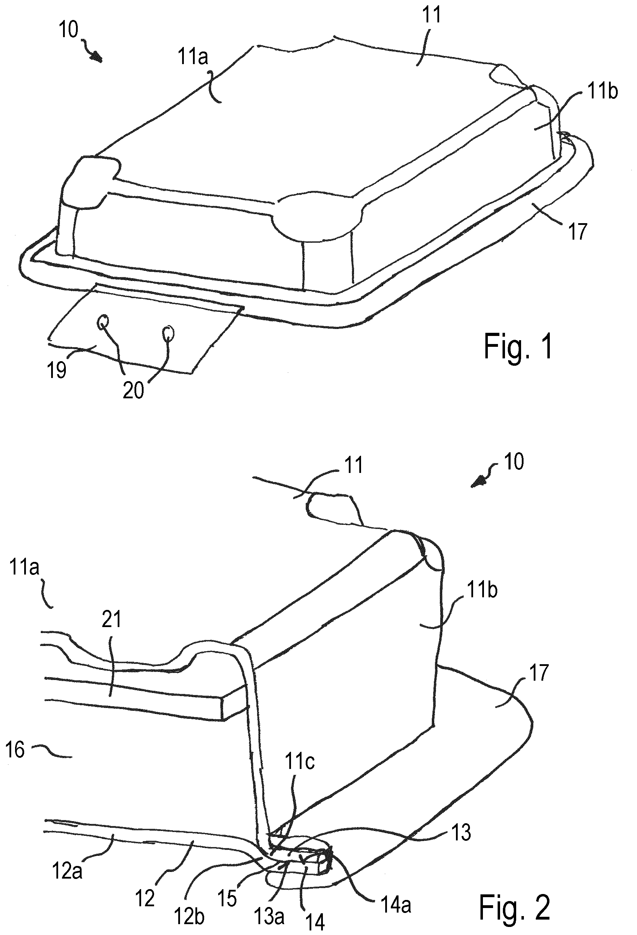

In Fig. 1 und 2 ist ein Gehäuse zu sehen, welches ein erstes Gehäuseteil 11 und ein zweites Gehäuseteil 12 aufweist. Die Gehäuseteile 11, 12 sind aus Metall hergestellt, insbesondere als Gussteile aus Aluminium oder als Stanzbiegeteile aus Aluminium oder Stahl.

Wie aus Fig. 2 ersichtlich ist, ist an dem Gehäuseteil 11 ein umlaufend abragender erster Flansch 13 und an dem Gehäuseteil 12 ein umlaufender zweiter Flansch 14 vorhanden. Der erste Flansch 13 erstreckt sich etwa rechtwinklig von einer Seitenwand 11b des ersten Gehäuseteils 11 und etwa parallel zu einer Hauptfläche 11a des ersten Gehäuseteils 11 nach außen. Die Seitenwand 11b und der erste Flansch 13 sind durch einen Übergangsbereich 11c miteinander verbunden, der insbesondere als Rundung ausgebildet sein kann. Der zweite Flansch 14 erstreckt sich etwa parallel zu einer Hauptfläche 12a des zweiten Gehäuseteils 12 nach außen. Der zweite Flansch 14 und die Hauptfläche 12a sind durch einen etwa schräg zu diesen verlaufenden Übergangsbereich 12b miteinander verbunden, sodass zwischen dem zweiten Flansch 14 und der Hauptfläche 12a eine umlaufende Stufe ausgebildet ist und der zweite Flansch 14 und die Hauptfläche 12a zueinander quer zu ihren jeweiligen Erstreckungsebenen versetzt sind. Das erste Gehäuseteil 11 liegt mit dem Übergangsbereich 11c insbesondere umlaufend an dem Übergangsbereich 12b an. Dadurch ergibt sich ein umlaufender Kontakt der beiden Gehäuseteile 11, 12, sodass sich diese automatisch ausrichten und gegen Verrutschen gesichert sind.

Die Flansche 13, 14 weisen jeweils eine Kontaktfläche 13a, 14a auf, an denen die Flansche 13, 14 aufeinander liegen und einen Kontaktbereich 15 definieren. Die Gehäuseteile 11, 12 bilden dadurch einen abgeschlossenen Hohlraum 16 zur Aufnahme einer Platine 21.

Um einerseits die Gehäuseteile 11, 12 miteinander zu verbinden und andererseits den Hohlraum 16 nach außen abzudichten, ist an den Kontaktbereich 15 umlaufend ein selbst außen um den Rand umlaufender Rahmen 17 aus Kunststoff derart angeformt, dass er die Flansche 13, 14 mit dem Kontaktbereich 15 vollständig umschließt. Um die Flansche 13, 14 zu umschließen, kann der Rahmen 17 im Querschnitt U-förmig ausgestaltet sein. Der Rahmen 17 kann durch Spritzgießen bzw. Anspritzen angeformt sein.

Der Rahmen 17 kann so gestaltet werden, dass eine Befestigungsplatte integriert ist. Der Rahmen 17 kann auch so gestaltet werden, dass Befestigungselemente wie z. B. Löcher oder Rippen in den Rahmen integriert ist.

Das Gehäuse 10 kann ein Befestigungselement aufweisen, das einen Beschlag (Befestigungsplatte 19) umfasst. An dem Gehäuse 10 können an unterschiedlichen Seiten auch mehrere Befestigungsplatten 19 angebracht sein, um das Gehäuse 10 sicher in einer Umgebungsstruktur, beispielsweise in einem Kraftfahrzeug, zu befestigen.

Die Befestigungsplatte 19 ist an dem Gehäuse 10 befestigt, indem es vor dem Anformen des Rahmens 17 an wenigstens einem der Flansche 13, 14 angebracht und dann der Rahmen 17 derart angeformt wird, dass er die Befestigungsplatte 19 mit den Flanschen 13, 14 umgibt. Das heißt, die Befestigungsplatte 19 ist durch den Rahmen 17 an dem Gehäuse 10 befestigt, indem der Rahmen 17 im Bereich der Befestigungsplatte 19 derart angeformt wird, dass ein Teil der Befestigungsplatte 19 zwischen wenigstens einem Flansch 13, 14 und den Rahmen 17 eingeschlossen ist und die Befestigungsplatte 19 dadurch festgelegt ist.

Bei der Montage des Gehäuses 10 werden das erste Gehäuseteil 11 und das zweite Gehäuseteil 12 zunächst in einem Formwerkzeug, insbesondere einem Spritzgusswerkzeug, angeordnet, sodass der erste Flansch 13 und der zweite Flansch 14 in dem Kontaktbereich 15 aufeinander liegen. Sodann wird die Befestigungsplatte 19 an wenigstens einem der Flansche 13, 14 angebracht. Schließlich wird der Rahmen 17 derart angeformt, insbesondere angespritzt, dass dieser umlaufend an dem Kontaktbereich 15 angebracht ist, den ersten Flansch 13 und den zweiten Flansch 14 umschließt und die Befestigungsplatte 19 festlegt.

Abhängig von den Anforderungen kann das komplett vormontierte Gehäuse in das Spritzgusswerkzeug eingelegt werden, um dann die beiden Gehäuseteile durch Spritzguss mit Hilfe des angespritzen Rahmens 17 zu verbinden.

### Bezugszeichenliste

- 10: Gehäuse
- 11: erstes Gehäuseteil
- 11a: Hauptfläche
- 11b: Seitenwand
- 11c: Übergangsbereich
- 12: zweites Gehäuseteil
- 12a: Hauptfläche
- 12b: Übergangsbereich
- 13: erster Flansch
- 13a: Kontaktfläche
- 14: zweiter Flansch
- 14a: Kontaktfläche
- 15: Kontaktbereich
- 16: Hohlraum
- 17: Rahmen
- 19: Befestigungsplatte
- 20: Öffnung
- 21: Platine

## Patentansprüche

1. Gehäuse (10), insbesondere für ein Steuergerät, umfassend ein erstes Gehäuseteil (11) aus Metall, welches einen umlaufend abragenden ersten Flansch (13) aufweist, und ein zweites Gehäuseteil (12) aus Metall, welches einen umlaufenden zweiten Flansch (14) aufweist,
wobei der erste Flansch (13) und der zweite Flansch (14) in einem Kontaktbereich (15) aufeinander liegen, sodass das erste Gehäuseteil (11) und das zweite Gehäuseteil (12) gemeinsam einen abgeschlossenen Hohlraum (16) begrenzen,
und **dadurch gekennzeichnet, dass** an den Kontaktbereich (15) ein Rahmen (17) aus Kunststoff selbst außen um den Rand umlaufend derart angeformt ist, dass er die Flansche (13, 14) mit dem Kontaktbereich (15) vollständig umschließt, um die Gehäuseteile (11, 12) miteinander zu verbinden und den Hohlraum (16) nach außen abzudichten.

2. Gehäuse (10) nach Anspruch 1, **gekennzeichnet durch** ein Befestigungselement zum Befestigen des Gehäuses (10) an einer Umgebungsstruktur.

3. Gehäuse (10) nach Anspruch 2, **dadurch gekennzeichnet, dass** das Befestigungselement wenigstens eine von dem Gehäuse (10) und/oder dem Rahmen (17) abragende Befestigungsplatte (19) aufweist.

4. Gehäuse (10) nach Anspruch 2 oder 3, **dadurch gekennzeichnet, dass** das Befestigungselement durch den Rahmen (17) an dem Gehäuse (10) befestigt ist.

5. Gehäuse (10) nach einem der Ansprüche 2 bis 4, **dadurch gekennzeichnet, dass** das Befestigungselement zwei von dem Gehäuse (10) und/oder dem Rahmen (17) abragende Befestigungsplatten (19) an gegenüberliegenden Seiten des Gehäuses (10) aufweist.

6. Gehäuse (10) nach einem der Ansprüche 1 bis 5, **gekennzeichnet durch** eine Platine (21), die in dem Hohlraum (16) angeordnet ist.

7. Gehäuse (10) nach einem der Ansprüche 1 bis 6, **dadurch gekennzeichnet, dass** der Rahmen (17) im Querschnitt U-förmig ausgebildet ist.

8. Gehäuse (10) nach einem der Ansprüche 1 bis 7, **dadurch gekennzeichnet, dass** das zweite Gehäuseteil (12) eine umlaufende Stufe aufweist, an der das erste Gehäuseteil (11) anliegt.

9. Verfahren zur Montage eines Gehäuses (10), umfassend ein erstes Gehäuseteil (11) aus Metall, welches einen umlaufend abragenden ersten Flansch (13) aufweist, und ein zweites Gehäuseteil (12) aus Metall, welches einen umlaufenden zweiten Flansch (14) aufweist, wobei das Verfahren die folgenden Schritte umfasst:
Anordnen des ersten Gehäuseteils (11) und des zweiten Gehäuseteils (12) in einem Formwerkzeug, insbesondere einem Spritzgusswerkzeug, sodass der erste Flansch (13) und der zweite Flansch (14) in einem Kontaktbereich (15) aufeinander liegen und das erste Gehäuseteil (11) und das zweite Gehäuseteil (12) gemeinsam einen abgeschlossenen Hohlraum (16) begrenzen, und **dadurch gekennzeichnet, dass** das Verfahren den folgenden Schritt aufweist:
Anformen, insbesondere Anspritzen, eines Rahmens (17) aus Kunststoff derart, dass dieser selbst außen um den Rand umlaufend derart an dem Kontaktbereich (15) angebracht ist, dass er die Flansche (13, 14) mit dem Kontaktbereich (15) vollständig umschließt.

10. Verfahren nach Anspruch 9, **dadurch gekennzeichnet, dass** vor dem Anformen des Rahmens (17) wenigstens eine von dem Gehäuse (10) und/oder dem Rahmen (17) abragende Befestigungsplatte (19) an wenigstens einem der Flansche (13, 14) angebracht wird und ein Teil der Befestigungsplatte (19) beim Anformen des Rahmens (17) zwischen dem Rahmen (17) und dem wenigstens einen Flansch (13, 14) eingeschlossen wird, um die Befestigungsplatte (19) an dem Gehäuse (10) zu befestigen.

11. Verfahren nach Anspruch 9 oder 10, **dadurch gekennzeichnet, dass** vor dem Anformen des Rahmens (17) eine Platine (21) in dem Hohlraum (16) angeordnet und insbesondere stoffschlüssig und/oder formschlüssig in dem Hohlraum (16) festgelegt wird.

## Claims

1. A housing (10), in particular for a control device, comprising a first housing part (11) made of metal, which has a peripherally projecting first flange (13), and a second housing part (12) made of metal, which has a peripherally projecting second flange (14),
wherein the first flange (13) and the second flange (14) lie above one another in a contact region (15) so that the first housing part (11) and the second housing part (12) together bound a closed cavity (16),
and **characterized in that**
a frame (17) made of plastic is itself molded to the contact region (15) in a manner revolving around the outside of the margin such that said frame (17) completely encloses the flanges (13, 14) with the contact region (15) in order to connect the housing parts (11, 12) to one another and to outwardly seal the cavity (16).

2. A housing (10) according to claim 1, **characterized by** a fastening element for fastening the housing (10) to a surrounding structure.

3. A housing (10) according to claim 2, **characterized in that** the fastening element has at least one fastening plate (19) projecting from the housing (10) and/or the frame (17).

4. A housing (10) according to claim 2 or 3, **characterized in that** the fastening element is fastened to the housing (10) by the frame (17).

5. A housing (10) according to any one of the claims 2 to 4, **characterized in that** the fastening element has two fastening plates (19), which project from the housing (10) and/or the frame (17), at oppositely disposed sides of the housing (10).

6. A housing (10) according to any one of the claims 1 to 5, **characterized by** a circuit board (21) which is arranged in the cavity (16).

7. A housing (10) according to any one of the claims 1 to 6, **characterized in that** the frame (17) is U-shaped in cross-section.

8. A housing (10) according to any one of the claims 1 to 7, **characterized in that** the second housing part (12) has a peripheral step which is contacted by the first housing part (11).

9. A method of assembling a housing (10) comprising a first housing part (11) made of metal, which has a peripherally projecting first flange (13), and a second housing part (12) made of metal, which has a peripherally projecting second flange (14), wherein the method comprises the following steps:
arranging the first housing part (11) and the second housing part (12) in a molding tool, in particular an injection molding tool, so that the first flange (13) and the second flange (14) lie above one another in a contact region (15) and the first housing part (11) and the second housing part (12) together bound a closed cavity (16), and **characterized in that** the method comprises the following step:
molding on, in particular injecting, a frame (17) made of plastic such that it is itself attached to the contact region (15) in a manner revolving around the outside of the margin such that said frame (17) completely encloses the flanges (13, 14) with the contact region (15).

10. A method according to claim 9, **characterized in that**, before the molding on of the frame (17), at least one fastening plate (19) projecting from the housing (10) and/or the frame (17) is attached to at least one of the flanges (13, 14) and, during the molding on of the frame (17), a part of the fastening plate (19) is enclosed between the frame (17) and the at least one flange (13, 14) to fasten the fastening plate (19) to the housing (10).

11. A method according to claim 9 or 10, **characterized in that**, before the molding on of the frame (17), a circuit board (21) is arranged in the cavity (16) and is in particular fixed in the cavity (16) in a bonded and/or form-fitting manner.

## Revendications

1. Boîtier (10), en particulier pour un appareil de commande, comprenant une première partie de boîtier (11) en métal qui présente une première bride (13) périphérique en saillie, et une deuxième partie de boîtier (12) en métal qui présente une deuxième bride (14) périphérique,
la première bride (13) et la deuxième bride (14) se trouvant l'une sur l'autre dans une zone de contact (15), de sorte que la première partie de boîtier (11) et la deuxième partie de boîtier (12) délimitent ensemble un espace creux fermé (16),
**caractérisé en ce que**
un cadre (17) en matière plastique est surmoulé sur la zone de contact (15), lequel s'étend lui-même à l'extérieur périphériquement autour du bord de manière à entourer complètement les brides (13, 14) avec la zone de contact (15) afin de relier les parties de boîtier (11, 12) entre elles et de rendre étanche l'espace creux (16) par rapport à l'extérieur.

2. Boîtier (10) selon la revendication 1,
**caractérisé par** un élément de fixation pour fixer le boîtier (10) à une structure environnante.

3. Boîtier (10) selon la revendication 2,
**caractérisé en ce que** l'élément de fixation comprend au moins une plaque de fixation (19) faisant saillie du boîtier (10) et/ou du cadre (17).

4. Boîtier (10) selon la revendication 2 ou 3,
**caractérisé en ce que** l'élément de fixation est fixé au boîtier (10) par le cadre (17).

5. Boîtier (10) selon l'une des revendications 2 à 4,
**caractérisé en ce que** l'élément de fixation comprend deux plaques de fixation (19), faisant saillie du boîtier (10) et/ou du cadre (17), sur des côtés opposés du boîtier (10).

6. Boîtier (10) selon l'une des revendications 1 à 5,
**caractérisé par** une platine (21) placée dans l'espace creux (16).

7. Boîtier (10) selon l'une des revendications 1 à 6,
**caractérisé en ce que** le cadre (17) a une section transversale en forme de U.

8. Boîtier (10) selon l'une des revendications 1 à 7,
**caractérisé en ce que** la deuxième partie de boîtier (12) présente un gradin périphérique contre lequel s'appuie la première partie de boîtier (11).

9. Procédé d'assemblage d'un boîtier (10) comprenant une première partie de boîtier (11) en métal qui présente une première bride (13) périphérique en saillie, et une deuxième partie de boîtier (12) en métal qui présente une deuxième bride (14) périphérique, le procédé comprenant les étapes suivantes consistant à :
placer la première partie de boîtier (11) et la deuxième partie de boîtier (12) dans un outil de moulage, en particulier dans un outil de moulage par injection, de sorte que la première bride (13) et la deuxième bride (14) se trouvent l'une sur l'autre dans une zone de contact (15) et que la première partie de boîtier (11) et la deuxième partie de boîtier (12) délimitent ensemble un espace creux fermé (16),
**caractérisé en ce que** le procédé comprend l'étape suivante consistant à :
surmouler, en particulier par injection, un cadre (17) en matière plastique de telle sorte que celui-ci soit appliqué sur la zone de contact (15) en s'étendant lui-même à l'extérieur périphériquement autour du bord de manière à entourer complètement les brides (13, 14) avec la zone de contact (15).

10. Procédé selon la revendication 9,
**caractérisé en ce que**, avant le surmoulage du cadre (17), au moins une plaque de fixation (19) faisant saillie du boîtier (10) et/ou du cadre (17) est montée sur l'une au moins des brides (13, 14), et une partie de la plaque de fixation (19) est emprisonnée entre le cadre (17) et ladite au moins une bride (13, 14) lors du surmoulage du cadre (17), afin de fixer la plaque de fixation (19) au boîtier (10).

11. Procédé selon la revendication 9 ou 10,
**caractérisé en ce que**, avant le surmoulage du cadre (17), une platine (21) est placée dans l'espace creux (16) et est fixée en particulier par coopération de matière et/ou par coopération de forme dans l'espace creux (16).
